# EUROPEAN PATENT SPECIFICATION

(11) **EP 4 306 973 B1**
(45) Date of publication and mention of the grant of the patent: **15.04.2026**
(21) Application number: 22184562.1
(22) Date of filing: 12.07.2022
(51) Int. Cl.: G01R 29/18

(54) **A SYSTEM AND A METHOD FOR ENERGISED CONDUCTOR PHASE IDENTIFICATION BASED ON SYNCHRONOUS MEASUREMENTS USING A NETWORK MODEL**
SYSTEM UND VERFAHREN ZUR IDENTIFIZIERUNG VON STROMFÜHRENDEN LEITERN BASIEREND AUF SYNCHRONEN MESSUNGEN UNTER VERWENDUNG EINES NETZWERKMODELLS
SYSTÈME ET PROCÉDÉ D'IDENTIFICATION DE PHASE DE CONDUCTEURS SOUS TENSION BASÉE SUR DES MESURES SYNCHRONES À L'AIDE D'UN MODÈLE DE RÉSEAU

(43) Date of publication of application: 17.01.2024
(73) Proprietor: Grid Instruments d.o.o., 1231 Crnuce (SI)
(72) Inventor: Kuhar, Urban, 1231 Crnuce (SI)
(74) Representative: Patentni Biro AF d.o.o.

(56) References cited:
- CN-A- 107 015 073
- US-A1- 2010 194 378
- US-A1- 2012 221 265
- US-A1- 2021 285 994
- US-B1- 8 533 121

## Description

### Technical field

The present invention belongs to the field of (distribution) power network measuring and testing, particularly to the phase identification of a power conductor. The invention relates to a system and a method for energised conductor phase identification based on synchronous measurements using a network model.

### Background of the invention and the technical problem

Power networks are used to deliver electrical energy from generating plants to customers. A wide spread grid is used for stable and safe delivery of electrical energy. In said grid, different voltage levels are used to keep ohmic losses as low as possible. Voltage levels are defined and depend on the country and possibly the area of operation and are changed on the transformer stations. Lowest voltage in the grid, which is in the majority of the world 240 or 120 volts, is then connected to residential and commercial users. Multiple conductor phases, normally three, are employed for the distribution and transmission. A phase attribute of A, B, C or 1, 2, 3 or u, v, w are typically assigned to each of the three conductors to identify them.

Conductor phases are usually assigned arbitrarily on the substation on the transmission or distribution level and later on serve as references, as the primary goal is to properly identify conductor phases within the substation area. But still greater benefits can arise if the whole network of a utility follows a single reference assignment of phases.

Knowledge on the conductor phase is important. There are situations when incorrect knowledge on the conductor phase may cause severe damage on equipment and can even present life-threatening situations to the operating personnel. An example of such a situation would be connecting two electricity sources together. Further, the load in the distribution network needs to be distributed as evenly as possible, as the network losses are thus lower and asset utilisation is greater.

In the networks, the phasing of conductors is often incorrect or even unknown. At the time of the construction of the grid the key points might have been labelled with the phase designation, but through daily operation the labelling is often lost or rendered false. The technical problem is development of a method for allowing identification of the conductor phase in a simple and reliable manner.

### Prior art

Various methods are known for tracking or identifying the phase of electrical conductors in the power grid. Phase identification instruments that rely on the synchrophasor measurements compare instantaneous phase measurements on two different locations collected at the same time. The first device, usually referred to as a reference unit, is located where the conductor phase is identified or assigned. The second device, usually referred to as a field unit, is located where the conductor phase is unknown.

Existing synchrophasor based phase identification instruments differ primarily in the variety of the data they use in the procedure of identifying the conductor phase. In documents US6642700 and US20100194378 a device and method that compare only instantaneous phase measurements were described. If the difference between the two measurements collected simultaneously is close to zero, the unknown conductor phase is the same as the one measured on the reference unit. If the measured difference is 120° or 240°, the unknown conductor phase is one of the other two options, depending on the regulations or utility selection of the phase rotation. For example, if the reference unit is measuring the A (or first) phase, and the field unit is also measuring the A (or first) phase, the difference between the instantaneous phase measurements is approximately 0°. If the field unit is measuring the B (or second) phase the difference between the instantaneous phase measurements is approximately 120° or 240°.

The main problem with usability of such devices is the complicated use of such a system, as the operator of the mobile unit needs to know the upstream network model to correctly account for transformer vector groups and field rotation or for other phase shifting devices. This problem can be mitigated with the use of measurement files stored and provided either by a field client or by a server as described in patent US9255954. The method is such that at the point of measurement the phase attribute is assigned by the user (either A, B, or C) and the measurement file stores the selected phase attribute along with the measured phase offset to one or more installed reference devices. This enables the user to use the stored or provided measurement file and apply the stored phase offsets in subsequent measurements removing the complexity of manually keeping track of phase offsets to the reference devices. The system, as such, behaves as if another reference device is installed at the point of measurement where the measurement file was created.

The drawback of the described method is that at the creation of the measurement file the user selects the phase attribute (either A, B, or C) and potentially two measurement files can be in conflict for the same point of measurement. Another related case would be, where application of two different measurement files that were created at different points would result in different phase determinations. Ultimately, it is the responsibility of the user to ensure coherent creation and application of measurement files. In addition, to have the benefit of measurement files, measurement files need to be created (distributed and maintained) which presents additional step(s) in the process.

US2021285994 discloses a method of phase identification, comprising:
- receiving voltage measurements, the voltage measurements including a plurality of customer voltage time series;
- obtaining distribution connectivity information;
- normalizing the plurality of customer voltage time series by their respective standard deviations;
- defining constraints for a clustering process by inspecting the distribution connectivity information;
- applying constrained and unconstrained clustering to partition customers into a plurality of clusters; and
- identifying a phase of each of the plurality of clusters by solving a minimization problem.

Furthermore, this document also discloses a system comprising:
- a computer-readable medium having instructions stored thereon, which, when executed by a processor, cause the system to:
- receive voltage measurements, the voltage measurements including a plurality of customer voltage time series;
- obtain distribution connectivity information;
- normalize the plurality of customer voltage time series by their respective standard deviations;
- define constraints for a clustering process by inspecting the distribution connectivity information;
- apply constrained clustering to partition customers into a plurality of clusters; and
- identify a phase of each of the plurality of clusters by solving a minimization problem.

This document uses a methodology of phase identification from collected data taken in longer time periods, which is in contrast with the present invention that allows phase identification in real time for a selected point in an analysed network.

### Description of the solution to the technical problem

The present invention aims to address the disadvantages of currently known devices and methods for conductor phase identification. The main contribution is that phase identification is enabled in real time. The technical problem is solved as defined in independent claims, wherein preferred embodiments of the invention are defined in dependent claims.

The usual system needed for identification of the conductor phase comprises at least one reference device installed in the inspected network and at least one field device connectable to the at least one reference device in order to compare the measurements. The reference device comprises a signal conditioning, data acquisition and processing modules, while the field device comprises signal conditioning, data acquisition, processing modules, and a user interface.

The essence of the invention is that the system further comprises a server unit connectable to said reference and field devices, wherein the server is provided with a network model comprising information about the network. This information includes at least data about connectivity, locations of network nodes, busbars, transformer units, field rotation at transformers, transformer vector groups, and other phase shifting devices present in the network. Thus, said server comprises a database of timestamped phasor measurements from all available reference devices in the same synchronous grid, a database of relevant part of the power network model where all busbars and lines are geotagged. Besides connectivity the network model contains information about transformer vector groups and field rotation, as well as information about any other phase shifting devices present in the network as this is essential information for correctly determining signal phase offset. These offsets can be specified by the manufacturer of the device or experimentally determined (measured on the field). In comparison to known methods, no measurements files are needed (stored measurements of phase offsets applied in subsequent measurements), but the identification of conductor phase is performed by matching the field device measurements to the selected reference device measurements, followed by application of the existing knowledge about network model (identification of transformers, field rotation, and connectivity in the network) and calculation of the phase shift from installed reference devices to all or selected busbars in the network model. Phase identification is enabled by a software for said identification and calculation installed and running either on the server, and/or the field device and/or the reference device, wherein the following steps are applied:
a) Connection of the field device to the server and receipt of a field measurement request by the server,
b) Checking of available reference devices and suggestion of the most suitable reference device for matching of measurements with the field device,
c) Obtaining the last available, accurate network model from either a file, database or other repository, usually Supervisory Control and Data Acquisition (SCADA) system, Advanced Distribution Management System (ADMS), or Geographic Information System (GIS),
d) Checking for calculated phase offset for the selected busbar in the network model,
   - If there are no phase offsets stored, phase offsets are calculated for all buses in the network model and stored in the database, or
   - If there are phase offsets stored, the database of selected reference devices is queried for the received field measurement request timestamp, the offset database is queried for the selected busbar and the found data are sent as results to the field device.

The network models and/or calculation modules are stored on the server unit, however, they could also be stored on either field or reference devices or any other third-party devices. This is less practical, hence the server configuration as described above is preferred.

The implementation of the phase offset calculation module can be done in multiple ways. One possible embodiment is to assume no-load conditions in the network and that for each bus with a reference device is assigned zero phase offset, wherein phase offsets for other busses in the network are calculated considering whether a connecting branch is a transformer or other phase shifting device and in case, it is, considering field rotation to determine the phase offset. The following recursive function is one example of such implementation:

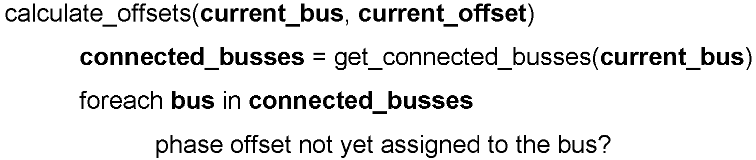

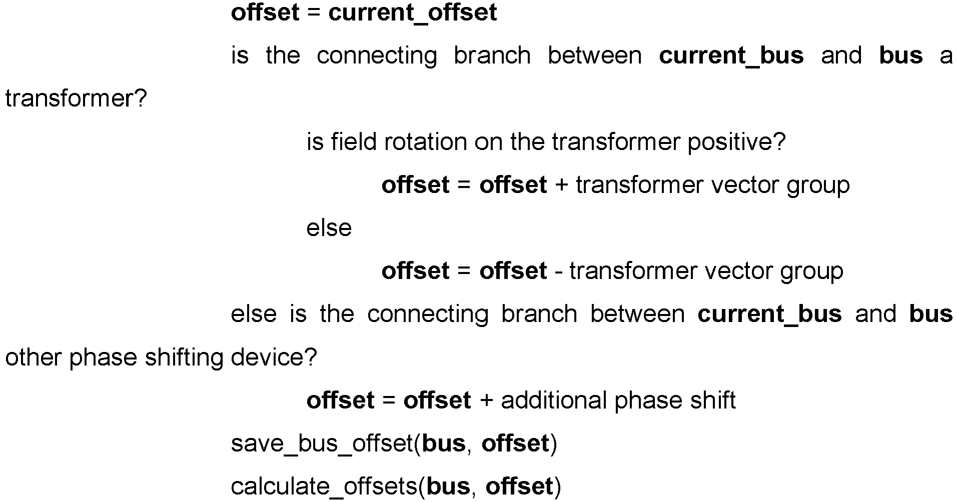

In other words, the method comprises the following:
- Offset at any selected reference device is assumed to be 0°,
- Checking of connected busses and connecting branch types, wherein for each identified connected bus, the system checks if there is a transformer or other phase shifting device in between; wherein, if yes, phase offset is added to the current phase offset with proper consideration of relevant parameters such as field rotation; and wherein if there is no phase shifting device between the busses, offset remains to be the previously assumed 0 for the connected bus,
- Repeating the above steps for each following bus connected to the previous bus to cover all connections in the relevant tested network or its part.

For larger networks, where line inductances are larger and loadings are significant, loads may need to be considered to correctly account for phase shifts that are the result of line currents. One possible way of implementation in such a network is that the three-phase or single-phase power-flow (Computer Analysis of Power Systems, Jos Arrillaga, C. P. Arnold, Wiley 1991) is calculated which results can be used to determine correct phase offsets between reference devices and other buses in the network.

The accurate operational network model enables the user to select the nearest available upstream busbar and the client or server software will recalculate the phase shift offset from one or more reference devices to the selected busbar. The phase shift offset can also be calculated using power-flow (Computer Analysis of Power Systems, Jos Arrillaga, C. P. Arnold, Wiley 1991) or similar technique under either nominal or any other load conditions.

Furthermore, the system preferably comprises a mobile application installed on a mobile device such as a smartphone, tablet or similar, wherein the mobile application is connectable to the field device and displays data about network model, calculated phases and related data. Said mobile application allows the entry of a correction of a specific parameter of the network model, such as transformer field rotation of vector group, to be applied on the server stored network model.

The present invention allows quick identification of conductor phases without any interventions in the power network.

The invention will be described in further detail based on exemplary embodiments and figures, which show:
- Figure 1a: Block diagram of the reference device
- Figure 1b: Flow-chart of the reference device operation
- Figure 2a: Block diagram of the field device
- Figure 2b: Flow-chart of the field device operation
- Figure 2c: Exemplary view of smartphone application for bus selection in a loaded network model
- Figure 2d: Exemplary view of smartphone application for phase identification
- Figure 3a: Databases on the server
- Figure 3b: Flow-chart of server operation
- Figure 4: An example of a power network model as stored and shown on web-server or smartphone application
- Figure 5: An example of a power network model as stored and shown on web-server or smartphone application with measurement file for a reference device in a synchronous zone

The system that implements the method according to the invention comprises at least three functional elements, namely at least one reference device, at least one field device and a server unit. Optionally, the field device is connectable to a mobile device with a mobile application displaying relevant data connected to the method of identification of conductor phase.

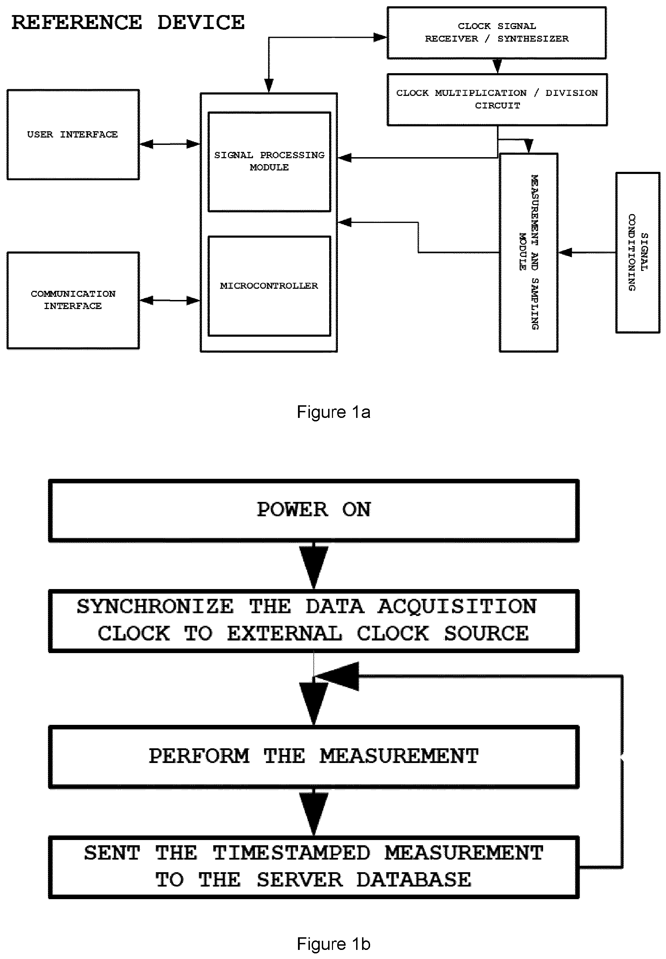

Figure 1a shows an embodiment of the reference device, which comprises signal conditioning, a module for measurement and sampling, a signal processing module, a microcontroller as well as clock signal receiver and clock multiplication/division circuit, which are interacting with the signal processing module and the module for measurement and sampling. The microcontroller communicates phasor estimations through a communication interface to the server. The user interface is used to present basic status information about the device, for example if the device is successfully connected to the server and if it is synchronised to the master clock.

The reference device operates in the following manner (Figure 1b): after signal conditioning and acquisition, the digitised signal of voltage or current is fed into phasor estimation algorithm, which produces the stream of time stamped phasor estimations (Synchronized Phasor Measurements and Their Applications, A.G. Phadke, J.S. Thorp, Springer 2008). The stream of phasor estimations is sent over the communication channel to the server.

If there are multiple reference devices installed in the network, care must be taken in connecting each of the devices following the first one in order that the new connected device follows the phase designation as it is used in the first device, considering the correct network model and phase offsets due to the model.

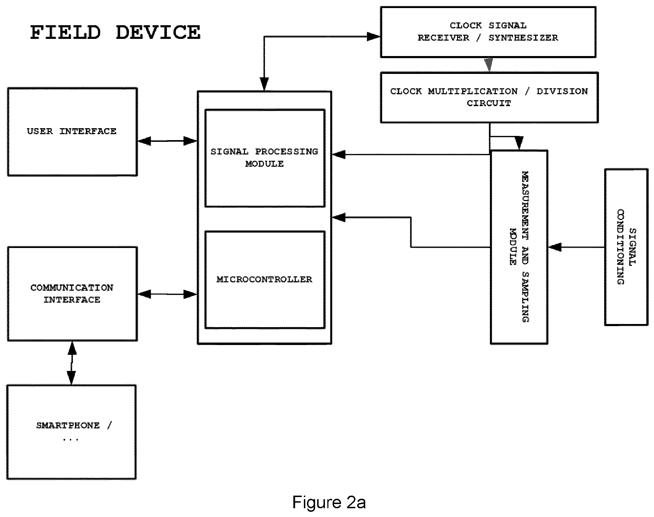

The field device is shown in Figure 2a and comprises signal conditioning, data acquisition (measurement and sampling module, clock signal receiver/synthesiser and clock multiplication/division circuit), a signal processing module in communication with a user interface, a microcontroller in communication with a communication interface optionally communicating with a smartphone or similar device.

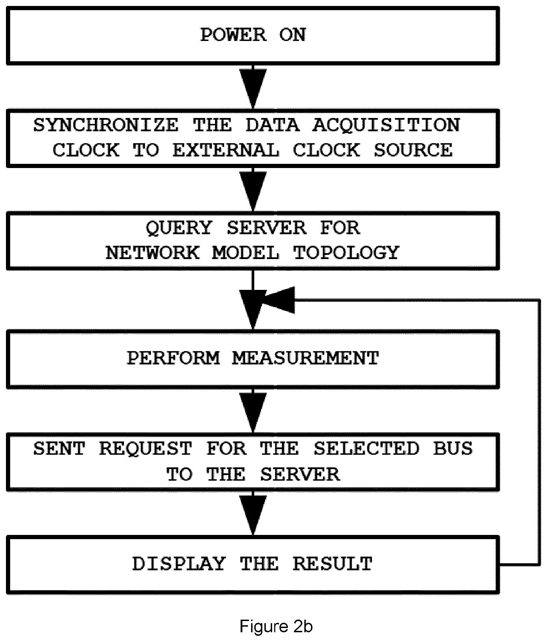

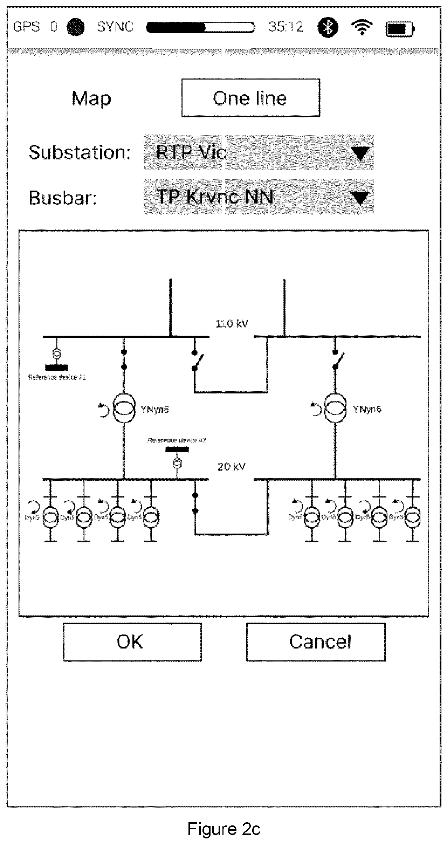

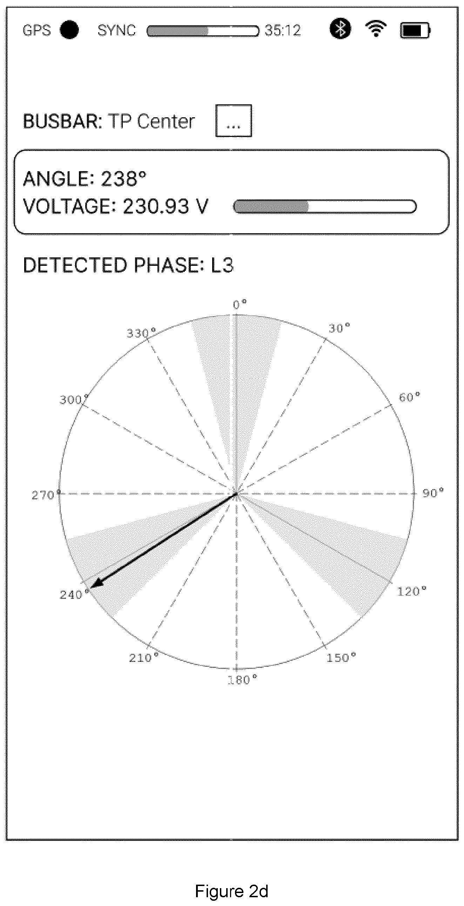

The flow-chart of the field device operation is shown in Figure 2b. After power-on the field device synchronises to the external clock source. Once synchronisation is achieved, the device starts performing measurements. The implementation of the device can be such that the field device connects to the smartphone via Bluetooth or other wireless or wired technology and streams the measurements to the mobile phone which serves as a user interface. The application on either the field device or smartphone (if smartphone is paired with the field device) then requests the network model for it to be presented to the user, wherein the network model is accessed via the server. Server responds with the network model and the user can select a bus in the network against which he wants to reference the measurements (Figure 2c). The selected bus is normally the closest one upstream in the network. Measurement acquisition is performed by conditioning of the voltage or current signal, its digitalization and processing which produces the phasor estimation (much like on the reference device). The phasor estimation result is then communicated to the microprocessor in the device or to an outside device such as a smartphone, where it is sent to the server with accompanying information about the selected network bus as a reference against which the measurement needs to be matched. Upon receiving the request, the server will query the database of reference measurements and return the matching reference measurement and then query the phase offset database for the selected network bus to correctly apply the offset and return the result to the user (see also the server operation flowchart). The result can be then displayed in the form of a phasor diagram (Figure 2d).

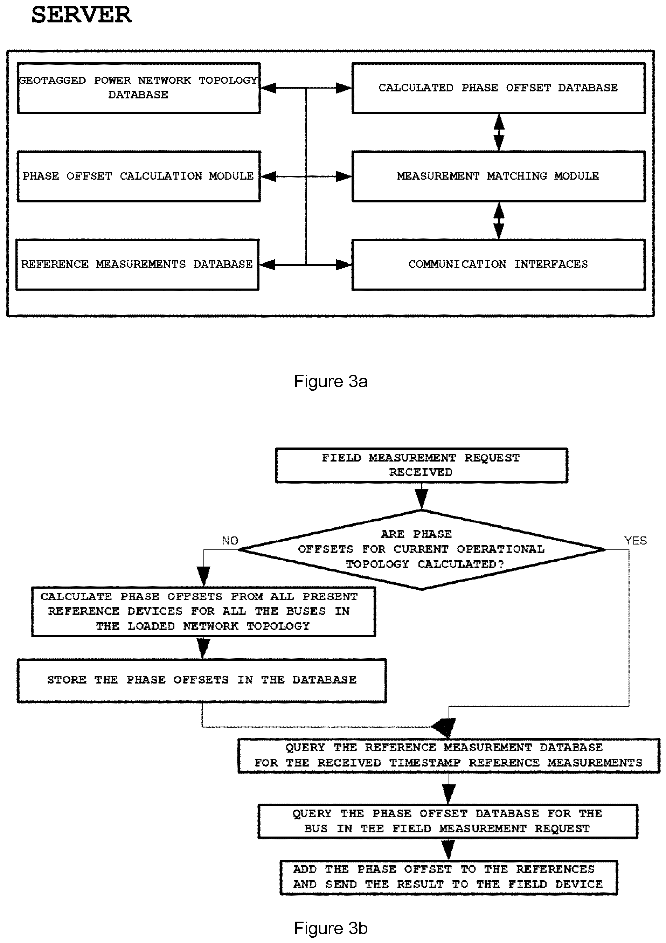

The server unit as shown in Figure 3a comprises:
- Accurate operational network model of the area where field measurements will be performed, which comprises:
   ∘ information about transformer vector groups and field rotation and/or other phase shifting devices in the network, as this is essential information for correctly determining signal phase offset,
   ∘ a database of relevant part of the power network model where all busbars and lines are geotagged, and
   ∘ a database with previously determined phase offsets for all available reference devices, matched to the buses in the said network model,
- a database of timestamped phasor measurements from all available reference devices,
- a communication module for communication with field and reference devices, and
- a measurement matching module for querying the database of reference measurements, matching the received field measurement request with the selected reference measurement and applying the calculated phase offset.

The preferred operation mode of the server once set up and provided with the necessary network model comprises the following steps (Figure 3b):
a) Connection of the field device and receipt of a field measurement request,
b) Checking of available reference devices and suggestion of the most suitable reference device for establishing connection with the field device,
c) Checking for calculated phase offsets for the selected network model,
   - If there are no offsets calculated, phase offsets are calculated for all buses in the network model and stored in the database, then
   - If there are offsets calculated, a database of reference measurements is queried for timestamp received in the field measurement request, the offset database is then queried and the returned data is sent as results to the field device.

The network model stored on the server comprises at least:
- information about the network connectivity,
- information about transformer vector groups and other phase shifting devices and
- information about field rotation on each of the transformers present in the network.

At least a part of the network model for the area where field measurements will be performed has to be available, which comprises at least one installed reference device or a measurement file that stores the phase offset to the reference device outside the said network model, but within the same synchronous zone, to a particular busbar in the stored network model (US9255954B2), down to the last transformer before the measurement point.

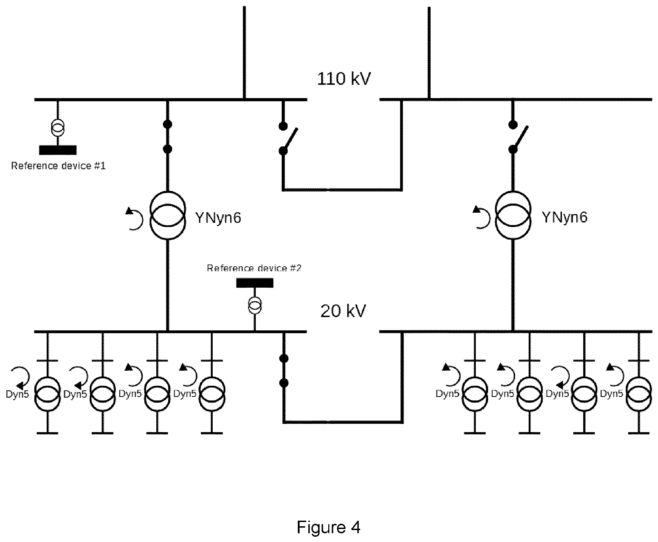

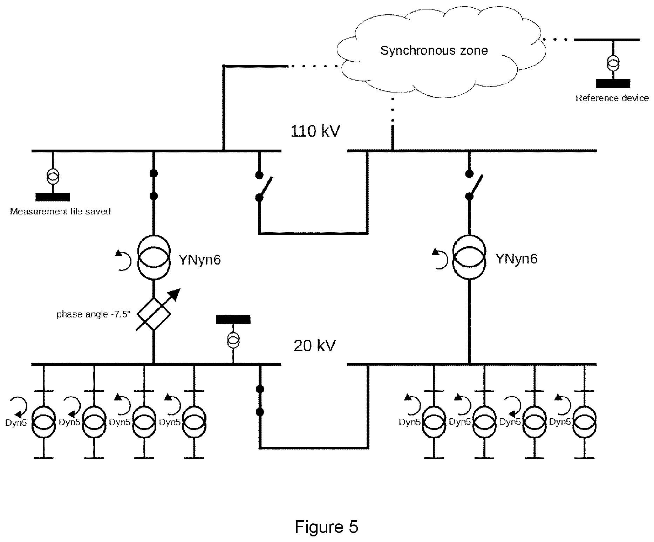

Figures 4 and 5 show examples of power network models consisting of said information about the network connectivity, transformer vector groups and field rotation on each of the transformers present in the network or information about other phase shifting devices present on the branches in the network.

The following recursive function represents the preferred embodiment of the invention:

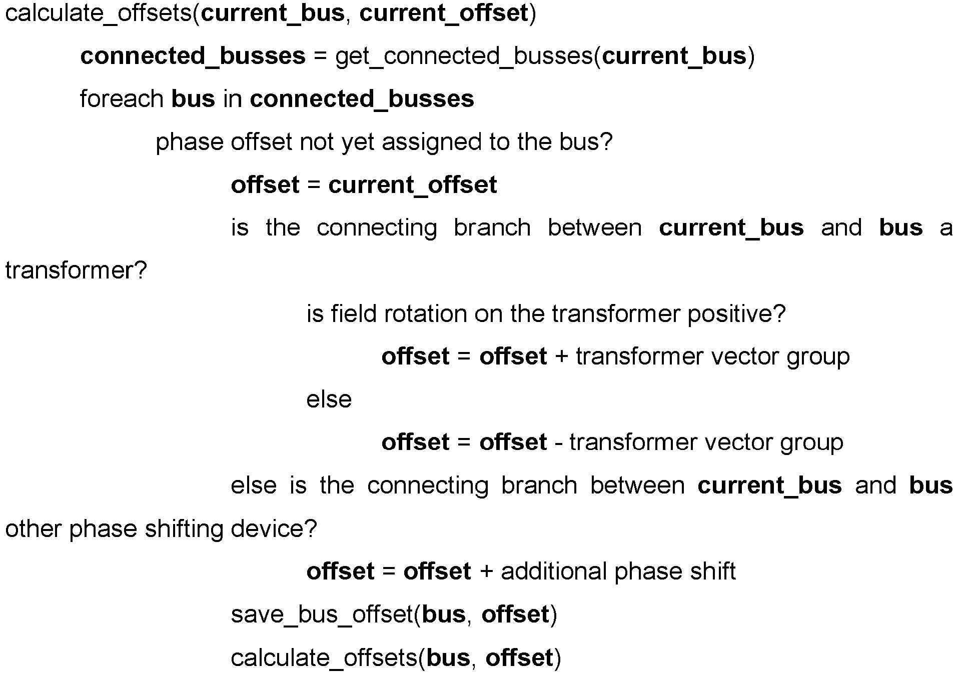

The implementation of the phase offset calculation according to a possible embodiment is thus the following:
- no-load condition in the network is assumed and
- for each bus with a reference device is assigned zero offset,
wherein offsets for other busses in the network are calculated considering whether a connecting branch is a transformer or other phase shifting device and in case, it is, considering field rotation to determine the phase offset.

The phase shift in case of transformers is determined based on information about the transformer connection, e.g., vector group 6 shifts the phases for 6*30°=180°.

## Claims

1. A system for performing a method for energised conductor phase identification based on synchronous measurements using a network model, wherein said system comprises:
- at least one reference device installed in an inspected network, or at least one reference device installed outside the inspected network, but within the same synchronous zone, and a measurement file that stores the phase offset from a particular busbar down to the last transformer in the model to the reference device outside the inspected network,
- at least one field device connected to the at least one reference device in order to obtain data about the inspected network,
**characterised in that** the system further comprises a server unit connected to said reference and field devices, wherein the server is provided with a network model comprising information about the inspected network, said information including at least data about connectivity, locations of network nodes, busbars, transformer units, field rotation at transformers, transformer vector groups, and other phase shifting devices present in the inspected network.

2. The system according to claim 1, wherein the reference device comprises a signal conditioning module, a data acquisition model and a processing module, while the field device comprises a signal conditioning module, a data acquisition module, a processing module, and a user interface.

3. The system according to claim 1 or claim 2, wherein the identification of conductor phase is performed by matching the field device measurements to the selected reference device measurements, followed by application of the existing knowledge about network model, including identification of transformers, field rotation, and connectivity in the network, and calculation of the phase offset from installed reference devices to all or selected busbars in the network model.

4. The system according to any of the preceding claims, wherein phase identification is enabled by a software for said identification and calculation installed and running either on the server, and/or the field device and/or the reference device, wherein the following steps are applied:
a) Connection of the field device to the server and receipt of a field measurement request by the server,
b) Checking of available reference devices and suggestion of the most suitable reference device for matching of measurements with the field device,
c) Obtaining the last available, accurate operational network model from either a file, database or other repository, preferably Supervisory Control and Data Acquisition (SCADA) system, Advanced Distribution Management System (ADMS), or Geographic Information System (GIS),
d) Checking for calculated phase offset for the selected busbar in the network model,
- If there are no phase offsets stored, phase offsets are calculated for all buses in the network model and stored in the database,
- If there are phase offsets stored, the database of selected reference device is queried for the received field measurement request timestamp, the offset database is queried for the selected busbar and the found data are sent as results to the field device.

5. The system according to any of the preceding claims, wherein the system further comprises a mobile application that can be installed on a mobile device such as a smartphone, tablet or similar, wherein the mobile application is connectable to the field device and displays data about network model, calculated phase offsets, phase identification result, and related data.

6. The system according to the preceding claim, wherein the mobile application allows the entry of a correction of a specific parameter of the network model, such as transformer field rotation or vector group number, to be applied on the server stored network model.

7. A method for energised conductor phase identification based on synchronous measurements using a network model performed by the system according to any of the preceding claims, said method comprising the following steps:
a) Connection of the field device to the server and receipt of a field measurement request by the server,
b) Checking of available reference devices and suggestion of the most suitable reference device for matching of measurements with the field device,
c) Obtaining the last available, accurate network model from either a file, database or other repository,
d) Checking for calculated phase offset for the selected busbar in the network model,
- If there are no phase offsets stored, phase offsets are calculated for all buses in the network model and stored in the database,
- If there are phase offsets stored, the database of selected reference devices is queried for the received field measurement request timestamp, the offset database is queried for the selected busbar and the found data are sent as results to the field device.

8. The method according to claim 7, wherein the step c) the network model is obtained from Supervisory Control and Data Acquisition (SCADA) system, Advanced Distribution Management System (ADMS), or Geographic Information System (GIS).

9. The method according to claim 7 or claim 8, wherein no-load conditions in the network are assumed and that for each bus with a reference device is assigned zero phase offset, wherein phase offsets for other busses in the network are calculated considering whether a connecting branch is a transformer or other phase shifting device and in case, it is, considering field rotation to determine the phase offset due to the said transformer or device.

10. The method according to claim 7, claim 8 or claim 9, wherein phase offset calculation module is implemented as a recursive function:

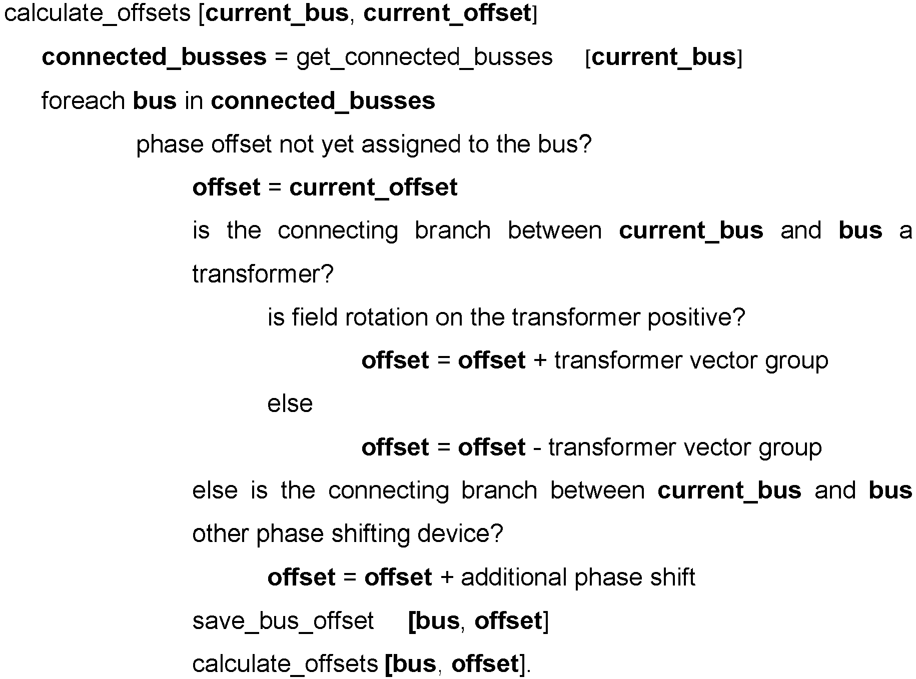

11. The method according to any of the preceding claims from 7 to 10, wherein for larger networks three-phase or single-phase power-flow is calculated and obtained results are used to determine correct phase offsets between reference devices and other buses in the network.

## Patentansprüche

1. System zum Durchführen eines Verfahrens zur Identifizierung der Phase von stromführenden Leitern basierend auf synchronen Messungen unter Verwendung eines Netzwerkmodells, wobei das System Folgendes umfasst:
- mindestens eine Referenzvorrichtung, die in einem geprüften Netzwerk installiert ist, oder mindestens eine Referenzvorrichtung, die außerhalb des geprüften Netzwerks, aber innerhalb derselben Synchronzone installiert ist, und eine Messdatei, die den Phasenversatz von einer bestimmten Sammelschiene zum letzten Transformator im Modell zu der Referenzvorrichtung außerhalb des geprüften Netzwerks speichert,
- mindestens eine Feldvorrichtung, die mit der mindestens einen Referenzvorrichtung verbunden ist, um Daten über das geprüfte Netzwerk zu erhalten,
**dadurch gekennzeichnet, dass** das System ferner eine Servereinheit umfasst, die mit der Referenz- und Feldvorrichtung verbunden ist, wobei der Server mit einem Netzwerkmodell versehen ist, das Informationen über das geprüfte Netzwerk umfasst, wobei die Informationen mindestens Daten über Konnektivität, Standorte von Netzwerkknoten, Sammelschienen, Transformatoreinheiten, Feldrotation an Transformatoren, Transformatorvektorgruppen und andere im geprüften Netzwerk vorhandene Phasenschieber einschließt.

2. Das System nach Anspruch 1, wobei die Referenzvorrichtung ein Signalaufbereitungsmodul, ein Datenerfassungsmodul und ein Verarbeitungsmodul umfasst, während die Feldvorrichtung ein Signalaufbereitungsmodul, ein Datenerfassungsmodul, ein Verarbeitungsmodul und eine Benutzerschnittstelle umfasst.

3. Das System nach Anspruch 1 oder 2, wobei die Identifizierung der Leiterphase durch Abgleichen der Feldvorrichtungsmessungen mit den Messungen der ausgewählten Referenzvorrichtung durchgeführt wird, gefolgt von der Anwendung des vorhandenen Wissens über das Netzwerkmodell, einschließlich der Identifizierung von Transformatoren, Feldrotation und Konnektivität im Netz, sowie der Berechnung des Phasenversatzes von installierten Referenzvorrichtungen zu allen oder ausgewählten Sammelschienen im Netzwerkmodell.

4. Das System nach einem der vorstehenden Ansprüche, wobei die Phasenidentifizierung durch eine Software für die Identifizierung und Berechnung ermöglicht wird, die entweder auf dem Server und/oder der Feldvorrichtung und/oder der Referenzvorrichtung installiert ist und ausgeführt wird, wobei die folgenden Schritte angewendet werden:
a) Verbinden der Feldvorrichtung mit dem Server und Empfang einer Feldmessanforderung durch den Server,
b) Prüfen der verfügbaren Referenzvorrichtungen und Empfehlung der am besten geeigneten Referenzvorrichtung zum Abgleichen der Messungen mit der Feldvorrichtung,
c) Erhalten des letzten verfügbaren, genauen Betriebsnetzwerkmodells aus einer Datei, Datenbank oder einem anderen Repository, vorzugsweise einem SCADA (Supervisory Control and Data Acquisition)-System, einem ADMS (Advanced Distribution Management System) oder einem GIS (Geographic Information System),
d) Prüfen des berechneten Phasenversatzes für die ausgewählte Sammelschiene im Netzwerkmodell,
- falls keine Phasenversätze gespeichert sind, werden Phasenversätze für alle Sammelschienen im Netzmodell berechnet und in der Datenbank gespeichert,
- falls Phasenversätze gespeichert sind, wird die Datenbank der ausgewählten Referenzvorrichtung nach dem Zeitstempel der empfangenen Feldmessanforderung gefragt, die Versatzdatenbank wird nach der ausgewählten Sammelschiene gefragt, und die gefundenen Daten werden als Ergebnisse an die Feldvorrichtung gesendet.

5. Das System nach einem der vorstehenden Ansprüche, wobei das System ferner eine mobile Anwendung umfasst, die auf einer mobilen Vorrichtung, wie einem Smartphone, Tablet oder Ähnlichem, installiert werden kann, wobei die mobile Anwendung mit der Feldvorrichtung verbunden werden kann und Daten über das Netzwerkmodell, berechnete Phasenversätze, das Ergebnis der Phasenidentifizierung und zugehörige Daten anzeigt.

6. Das System nach dem vorstehenden Anspruch, wobei die mobile Anwendung die Eingabe einer Korrektur eines spezifischen Parameters des Netzwerkmodells, wie der Transformatorfeldrotation oder der Vektorgruppennummer, ermöglicht, die auf das auf dem Server gespeicherte Netzwerkmodell angewendet werden soll.

7. Verfahren zur Identifizierung der Phase von stromführenden Leitern basierend auf synchronen Messungen unter Verwendung eines Netzwerkmodells, das vom System ausgeführt wird, gemäß einem der vorstehenden Ansprüche, wobei das Verfahren die folgenden Schritte umfasst:
a) Verbinden der Feldvorrichtung mit dem Server und Empfang einer Feldmessanforderung durch den Server,
b) Prüfen der verfügbaren Referenzvorrichtungen und Empfehlung der am besten geeigneten Referenzvorrichtung zum Abgleichen der Messungen mit der Feldvorrichtung,
c) Erhalten des letzten verfügbaren, genauen Netzwerkmodells aus einer Datei, Datenbank oder einem anderen Repository,
d) Prüfen des berechneten Phasenversatzes für die ausgewählte Sammelschiene im Netzwerkmodell,
- falls keine Phasenversätze gespeichert sind, werden Phasenversätze für alle Sammelschienen im Netzmodell berechnet und in der Datenbank gespeichert,
- falls Phasenversätze gespeichert sind, wird die Datenbank ausgewählter Referenzvorrichtungen nach dem Zeitstempel der empfangenen Feldmessanforderung gefragt, die Versatzdatenbank wird nach der ausgewählten Sammelschiene gefragt, und die gefundenen Daten werden als Ergebnisse an die Feldvorrichtung gesendet.

8. Das Verfahren nach Anspruch 7, wobei in Schritt c) das Netzwerkmodell aus einem SCADA (Supervisory Control and Data Acquisition)-System, einem ADMS (Advanced Distribution Management System) oder einem GIS (Geographic Information System) erhalten wird.

9. Das Verfahren nach Anspruch 7 oder Anspruch 8, wobei von Leerlaufbedingungen im Netzwerk ausgegangen wird und jedem Bus mit einer Referenzvorrichtung ein Phasenversatz von Null zugewiesen wird, wobei Phasenversätze für andere Busse im Netz unter Berücksichtigung dessen berechnet werden, ob es sich bei einem Verbindungszweig um einen Transformator oder eine andere Phasenverschiebungsvorrichtung handelt, und falls ja, unter Berücksichtigung der Feldrotation, um den durch den Transformator oder die Vorrichtung verursachten Phasenversatz zu bestimmen.

10. Das Verfahren nach Anspruch 7, Anspruch 8 oder Anspruch 9, wobei das Modul zur Berechnung des Phasenversatzes als rekursive Funktion implementiert ist:

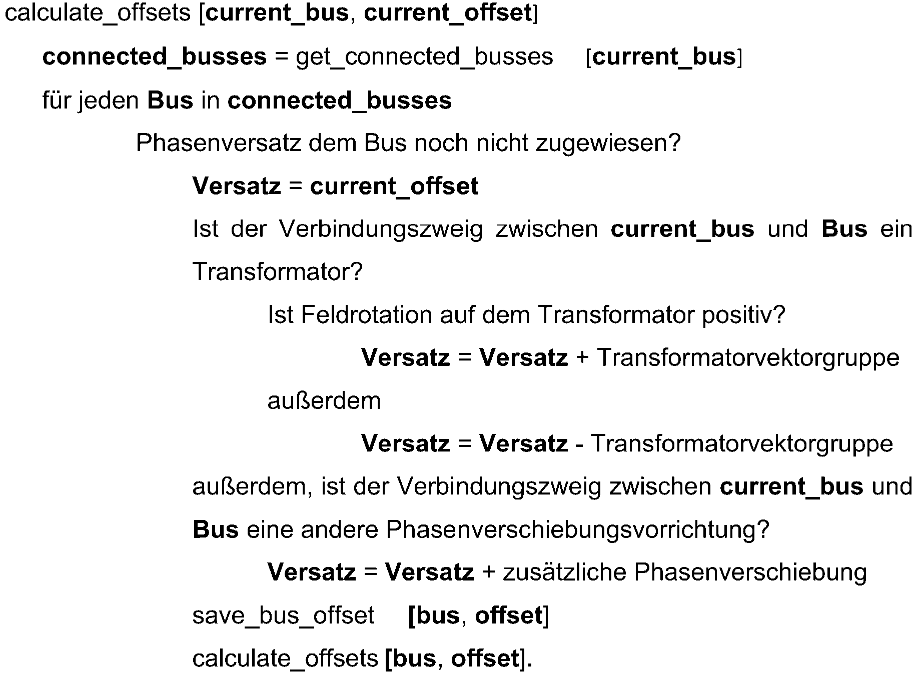

11. Das Verfahren nach einem der vorstehenden Ansprüche 7 bis 10, wobei für größere Netzwerke der dreiphasige oder einphasige Lastfluss berechnet wird und die erhaltenen Ergebnisse zum Bestimmen korrekter Phasenversätze zwischen Referenzvorrichtungen und anderen Bussen im Netz verwendet werden.

## Revendications

1. Système d'identification de phase de conducteurs sous tension basée sur des mesures synchrones à l'aide d'un modèle de réseau, ledit système comprenant :
- Au moins un dispositif de référence installé dans un réseau inspecté, ou au moins un dispositif de référence installé en dehors du réseau inspecté, mais à l'intérieur de la même zone synchrone, et un fichier de mesures qui stocke le décalage de phase depuis une barre omnibus donnée jusqu'au dernier transformateur du modèle dans le dispositif de référence en dehors du réseau inspecté,
- Au moins un dispositif de terrain relié à au moins un dispositif de référence afin de recueillir des données sur le réseau inspecté,
**caractérisé par le fait que** le système comprend également un serveur relié auxdits dispositifs de référence et de terrain, où le serveur est pourvu d'un modèle de réseau comprenant des informations sur le réseau inspecté, lesdites informations comprenant au moins des données sur la connectivité, les emplacements de nœuds de réseau, barres omnibus, transformateurs, rotation de champ au niveau des transformateurs, groupes vectoriels de transformateur et autres dispositifs de déphasage présents dans le réseau inspecté.

2. Système selon la revendication 1, où le dispositif de référence comprend un module de conditionnement de signal, un modèle d'acquisition de données et un module de traitement, tandis que le dispositif de terrain comprend un module de conditionnement de signal, un module d'acquisition de données, un module de traitement et une interface utilisateur.

3. Système selon la revendication 1 ou la revendication 2, où l'identification de la phase des conducteurs est effectuée en comparant les mesures du dispositif de terrain aux mesures du dispositif de référence sélectionné, suivie par l'application des connaissances existantes sur le modèle de réseau, y compris l'identification des transformateurs, de la rotation de champ et de la connectivité dans le réseau, et le calcul du décalage de phase depuis les dispositifs de référence installés jusqu'à toutes les barres omnibus ou celles sélectionnées dans le modèle de réseau.

4. Système selon l'une quelconque des revendications précédentes, dans lequel l'identification de phase est permise par un logiciel destiné à ladite identification et au calcul, installé et fonctionnant soit sur le serveur, et/ou sur le dispositif de terrain et/ou le dispositif de référence, où les étapes suivantes sont appliquées :
a) Connexion du dispositif de terrain au serveur et réception d'une demande de mesure sur le terrain par le serveur,
b) Vérification des dispositifs de référence disponibles et suggestion du dispositif de référence le plus approprié pour la comparaison des mesures avec le dispositif de terrain,
c) Obtention du dernier modèle de réseau opérationnel, exact et disponible, provenant soit d'un fichier ou d'une base de données, soit d'un autre référentiel, de préférence un Système de contrôle et d'acquisition des données (SCADA), un Système avancé de gestion de la distribution (ADMS), ou un Système d'information géographique (SIG),
d) Contrôle du décalage de phase calculé pour la barre omnibus sélectionnée dans le modèle de réseau,
- S'il n'y a pas de décalages de phase stockés, les décalages de phase sont calculés pour tous les bus dans le modèle de réseau et sont stockés dans la base de données,
- Si des décalages de phase sont stockés, la base de données du dispositif de référence sélectionné est interrogée concernant l'horodatage de la demande de mesure sur le terrain reçue, la base de données de décalage est interrogée concernant la barre omnibus sélectionnée et les données trouvées sont envoyées comme résultats au dispositif de terrain.

5. Système selon l'une quelconque des revendications précédentes, le système comprenant en outre une application mobile qui peut être installée sur un appareil mobile tel qu'un smartphone, une tablette ou similaire, où l'application mobile est connectable au dispositif de terrain et affiche des données sur le modèle de réseau, les décalages de phase calculés, le résultat de l'identification de phase et les données connexes.

6. Système selon la revendication précédente, où l'application mobile permet la saisie de la correction d'un paramètre spécifique du modèle de réseau, tel que la rotation de champ d'un transformateur ou le numéro de groupe vectoriel, à appliquer sur le modèle de réseau stocké sur serveur.

7. Procédé d'identification de phase de conducteurs sous tension basée sur des mesures synchrones à l'aide d'un modèle de réseau, réalisé par le système selon l'une quelconque des revendications précédentes, ledit procédé comprenant les étapes suivantes :
a) Connexion du dispositif de terrain au serveur et réception d'une demande de mesure sur le terrain par le serveur,
b) Contrôle des dispositifs de référence disponibles et suggestion du dispositif de référence le plus approprié pour la comparaison des mesures avec le dispositif de terrain,
c) Obtention du dernier modèle de réseau exact disponible provenant soit d'un fichier, d'une base de données, soit d'un autre référentiel,
d) Contrôle du décalage de phase calculé pour la barre omnibus sélectionnée dans le modèle de réseau,
- Si aucun décalage de phase n'est stocké, les décalages de phase sont calculés pour tous les bus dans le modèle de réseau et sont stockés dans la base de données,
- Si des décalages de phase sont stockés, la base de données des dispositifs de référence sélectionnés est interrogée concernant l'horodatage de la demande de mesure de terrain reçue, la base de données de décalages est interrogée concernant la barre omnibus sélectionnée et les données trouvées sont envoyées comme résultats au dispositif de terrain.

8. Procédé selon la revendication 7, dans lequel le modèle de réseau de l'étape c) est obtenu par le biais d'un Système de contrôle et d'acquisition de données (SCADA), un Système avancé de gestion de la distribution (ADMS) ou un Système d'information géographique (SIG).

9. Procédé selon la revendication 7 ou la revendication 8, dans lequel des conditions à vide dans le réseau sont présumées et où pour chaque bus avec un dispositif de référence, un décalage de phase nul est attribué, où les décalages de phase pour les autres bus du réseau sont calculés en prenant en considération le fait qu'un embranchement de connexion puisse être un transformateur ou un autre type de dispositif de déphasage et si c'est le cas, en prenant en considération la rotation de champ pour déterminer le décalage de phase dû audit transformateur ou dispositif.

10. Procédé selon la revendication 7, la revendication 8 ou la revendication 9, où le module de calcul de décalage de phase est mis en œuvre en tant que fonction récursive :

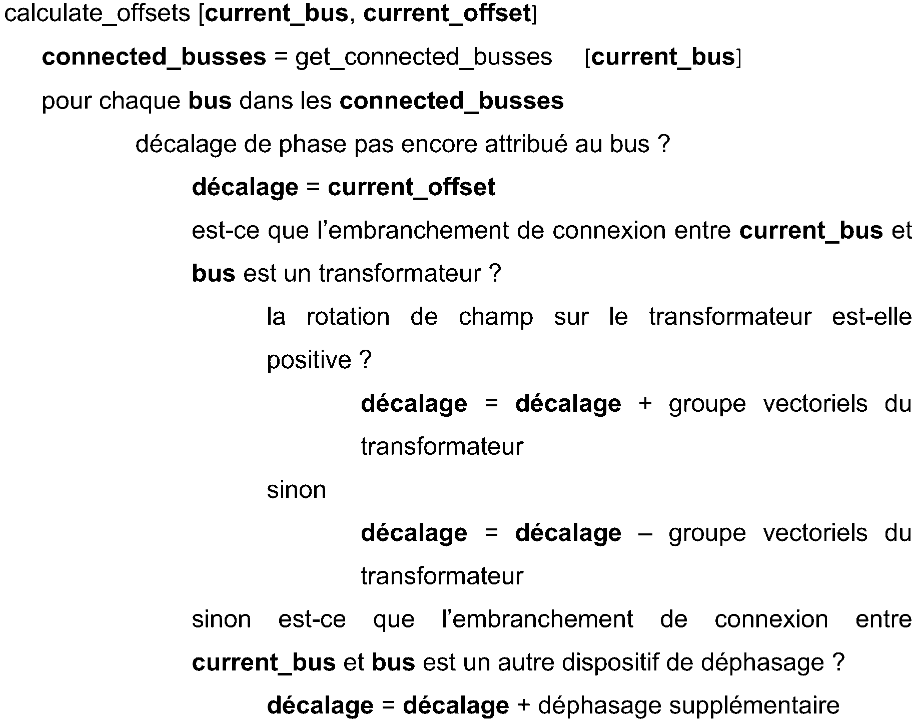

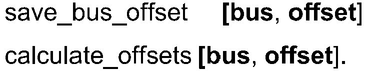

11. Procédé selon l'une quelconque des revendications 7 à 10, où pour les grands réseaux, un flux électrique triphasé ou monophasé est calculé et les résultats obtenus sont utilisés pour déterminer les décalages de phase corrects entre les dispositifs de référence et les autres bus du réseau.
